# EUROPEAN PATENT APPLICATION

(11) **EP 4 391 080 A1**
(43) Date of publication of application: **26.06.2024**
(21) Application number: 23209977.0
(22) Date of filing: 15.11.2023
(51) Int. Cl.: H01L 29/778, H01L 21/337, H01L 29/06, H01L 29/10, H01L 29/207, H01L 29/20

(54) **ENHANCEMENT MODE GALLIUM NITRIDE TRANSISTOR**

(30) Priority: 21.12.2022 US 202218069802
(71) Applicant: Analog Devices, Inc., Wilmington, MA 01887 (US)
(72) Inventor: PIEDRA, Daniel, Wilmington, 01887 (US); FIORENZA, James, Wilmington, 01887 (US)
(74) Representative: Horler, Philip John

(57) **Abstract**

Techniques are disclosed to fabricate an enhancement mode HEMT device where the normally off characteristic is implemented through the backside of the device by epitaxially growing a semiconductor layer (104), such as aluminum nitride (AlN) or aluminum gallium nitride (AlGaN), to deplete a two-dimensional electron gas (2DEG) channel (112). This buried semiconductor layer (104), e.g., a buried AlN or AlGaN layer, advantageously maintains a high transconductance and is more amenable to gate scaling than other enhancement mode techniques.

## Description

### FIELD OF THE DISCLOSURE

This document pertains generally, but not by way of limitation, to semiconductor devices, and more particularly, to techniques for constructing gallium nitride devices.

### BACKGROUND

Gallium nitride (GaN) based semiconductors offer several advantages over other semiconductors as the material of choice for fabricating the next generation of transistors, or semiconductor devices, for use in both high voltage and high frequency applications. GaN based semiconductors, for example, have a wide bandgap that enable devices fabricated from these materials to have a high breakdown electric field and to be robust to a wide range of temperatures.

The two-dimensional electron gas (2DEG) channels formed by GaN based heterostructures generally have high electron mobility, making devices fabricated using these structures useful in power-switching and amplification systems. GaN based semiconductors, however, are typically used to fabricate depletion mode (or normally on) devices, which can have limited use in many of these systems, such as due to the added circuit complexity required to support such devices.

### SUMMARY OF THE DISCLOSURE

This disclosure describes, among other things, techniques to fabricate an enhancement mode HEMT device where the normally off characteristic is implemented through the backside of the device by epitaxially growing a semiconductor layer, such as aluminum nitride (AlN) or aluminum gallium nitride (AlGaN), to deplete a two-dimensional electron gas (2DEG) channel. This buried semiconductor layer, e.g., a buried AlN or AlGaN layer, advantageously maintains a high transconductance and is more amenable to gate scaling then other enhancement mode techniques.

In some aspects, this disclosure is directed to a compound semiconductor heterostructure transistor device comprising: a substrate; a first semiconductor material layer formed over the substrate, wherein the first semiconductor material layer includes a mesa-shaped region; a second semiconductor material layer formed over the first semiconductor material layer; a third semiconductor material layer formed over the second semiconductor material layer to form a compound semiconductor heterostructure having a two-dimensional electron gas (2DEG) channel, wherein the 2DEG channel is more conductive than either the second semiconductor material layer or the third semiconductor material layer; a drain electrode electrically coupled to the 2DEG channel; a source electrode electrically coupled to the 2DEG channel; and a gate electrode formed over the third semiconductor material layer.

In some aspects, this disclosure is directed to a method of forming a compound semiconductor heterostructure transistor device, the method comprising: forming a first semiconductor material layer over a substrate, wherein the first semiconductor material layer includes a mesa-shaped region; forming a second semiconductor material layer over the first semiconductor material layer; forming a third semiconductor material layer over the second semiconductor material layer to form a compound semiconductor heterostructure having a two-dimensional electron gas (2DEG) channel, wherein the 2DEG channel is more conductive than either the second semiconductor material layer or the third semiconductor material layer; coupling a drain electrode electrically to the 2DEG channel; coupling a source electrode electrically to the 2DEG channel; and forming a gate electrode over the third semiconductor material layer.

In some aspects, this disclosure is directed to a compound semiconductor heterostructure transistor device comprising: a substrate; a first semiconductor material layer formed over the substrate, wherein the first semiconductor material layer includes a mesa-shaped region; a second semiconductor material layer formed over the first semiconductor material layer; a third semiconductor material layer formed over the second semiconductor material layer to form a compound semiconductor heterostructure having a two-dimensional electron gas (2DEG) channel, wherein the 2DEG channel is more conductive than either the second semiconductor material layer or the third semiconductor material layer; a drain electrode electrically coupled to the 2DEG channel; a source electrode electrically coupled to the 2DEG channel; a gate electrode formed over the second semiconductor material layer; and a fourth semiconductor material layer formed over the third semiconductor material layer and under the gate electrode.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 depicts a cross-sectional diagram of an example of a compound semiconductor heterostructure transistor device that can implement various techniques of this disclosure.
FIGS. 2A-2E depict an example of a process flow for fabricating an enhancement mode compound semiconductor heterostructure transistor device, in accordance with this disclosure.
FIG. 3 is a flow diagram of an example of a method of forming a compound semiconductor heterostructure transistor device.

### DETAILED DESCRIPTION

For most power applications, an enhancement mode switch is desired for safety and to minimize circuit complexity. However, gallium nitride (GaN) high electron mobility transistors (HEMTs) are naturally depletion mode. To make the most of such devices, an enhancement mode solution is desirable. Several normally off GaN technologies exist currently, such as gate recess, p-GaN gate, and fluorine treatment. Each of these options involves some modification to the top side of the device.

The present inventors have recognized a need for an alternative enhancement mode solution to HEMT devices. This disclosure describes techniques to fabricate an enhancement mode HEMT device where the normally off characteristic is implemented through the backside of the device by epitaxially growing a semiconductor layer, such as aluminum nitride (AlN) or aluminum gallium nitride (AlGaN), to deplete a two-dimensional electron gas (2DEG) channel. This buried semiconductor layer, e.g., a buried AlN or AlGaN layer, advantageously maintains a high transconductance and is more amenable to gate scaling then other enhancement mode techniques.

As used in this disclosure, a GaN-based compound semiconductor material can include a chemical compound of elements including GaN and one or more elements from different groups in the periodic table. Such chemical compounds can include a pairing of elements from group 13 (i.e., the group comprising boron (B), aluminum (Al), gallium (Ga), indium (In), and thallium (Tl)) with elements from group 15 (i.e., the group comprising nitrogen (N), phosphorus (P), arsenic (As), antimony (Sb), and bismuth (Bi)). Group 13 of the periodic table can also be referred to as Group III and group 15 as Group V. In an example, a semiconductor device can be fabricated from GaN and aluminum indium gallium nitride (AlInGaN).

Heterostructures described herein can be formed as AlN / GaN / AlN heterostructures, InAlN / GaN heterostructures, AlGaN/GaN heterostructures, or heterostructures formed from other combinations of group 13 and group 15 elements. These heterostructures can form a two-dimensional electron gas (2DEG) at the interface of the compound semiconductors that form the heterostructure, such as the interface of GaN and AlGaN. The 2DEG can form a conductive channel of electrons that can be controllably depleted, such as by an electric field formed by a buried layer of p-type material disposed below the channel. The conductive channel of electrons that can also be controllably enhanced, such as by an electric field formed by a gate terminal disposed above the channel to control a current through the semiconductor device. Semiconductor devices formed using such conductive channels can include high electron mobility transistor (HEMT) devices.

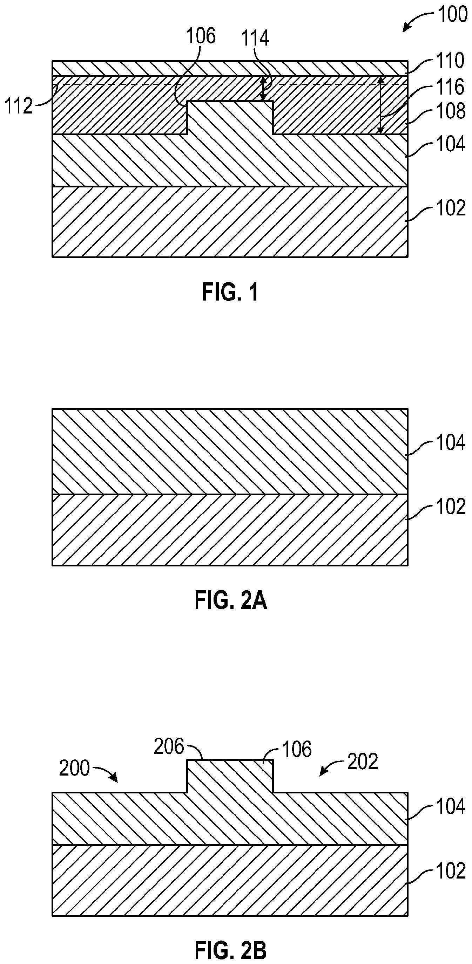

FIG. 1 depicts a cross-sectional diagram of an example of a compound semiconductor heterostructure transistor device 100 that can implement various techniques of this disclosure. The compound semiconductor heterostructure transistor device 100 is an example of an enhancement mode HEMT device. The compound semiconductor heterostructure transistor device 100 includes a substrate 102, such as silicon (Si), silicon carbide (SiC), and sapphire.

A first semiconductor material layer 104, e.g., a buried semiconductor layer, is formed over the substrate 102. For example, the first semiconductor material layer 104 can include AlGaN or AlN, e.g., a buried AlGaN or AlN layer. As seen in FIG. 1, the first semiconductor material layer 104 includes a mesa-shaped region 106. A second semiconductor material layer 108 is formed over the first semiconductor material layer 104. For example, the second semiconductor material layer 108 can include gallium nitride.

A third semiconductor material layer 110 is formed over the second semiconductor material layer 108 to form a compound semiconductor heterostructure having a two-dimensional electron gas (2DEG) channel 112 (illustrated as a dashed line), where the 2DEG channel is more conductive than either the second semiconductor material layer 108 or the third semiconductor material layer 110. For example, the third semiconductor material layer 110 can include AlGaN.

The distance between the mesa-shaped region 106 of the first semiconductor material layer 104 and the third semiconductor material layer 110 is shown at 114. The distance between the first semiconductor material layer 104 and the third semiconductor material layer 110, on either side of the mesa-shaped region 106, is shown at 116. The mesa-shaped region 106 creates two distinct regions: 1) a first region where the first semiconductor material layer 104 is close to the third semiconductor material layer 110, which is the region above the mesa-shaped region 106 and below the third semiconductor material layer 110; and 2) a second region where the first semiconductor material layer 104 is further away from the third semiconductor material layer 110, which includes the regions on either side of the mesa-shaped region 106.

The normally off characteristic of the enhancement mode HEMT device of FIG. 1 is implemented through the backside of the device such as by epitaxially growing the first semiconductor material layer 104, which can deplete the two-dimensional electron gas (2DEG) channel 112 in the region above the mesa-shaped region 106. The depletion of the channel 112 is represented in FIG. 1 by the break in the dashed line that represents the channel 112. This buried semiconductor layer 104 advantageously maintains a high transconductance and is more amenable to gate scaling then other enhancement mode techniques.

Without being bound by theory, as the distance 116 decreases between the first semiconductor material layer 104, e.g., AlGaN or AlN, and the third semiconductor material layer 110, e.g., AlGaN or AlN, the electron concentration decreases. The present inventors recognized that by including the mesa-shaped region 106 such that there is a distance 114 that is less than the distance 116 between the first semiconductor material layer 104 and the third semiconductor material layer 110, the electron concentration above the above the mesa-shaped region 106 will be less than the electron concentration on either side of the mesa-shaped region 106. The large band gap of the first semiconductor material layer 104 pulls up the conduction band at the heterojunction of the third semiconductor material layer 110 and the second semiconductor material layer 108. Pulling up the conduction band causes lower electron concentration in the 2DEG channel 112.

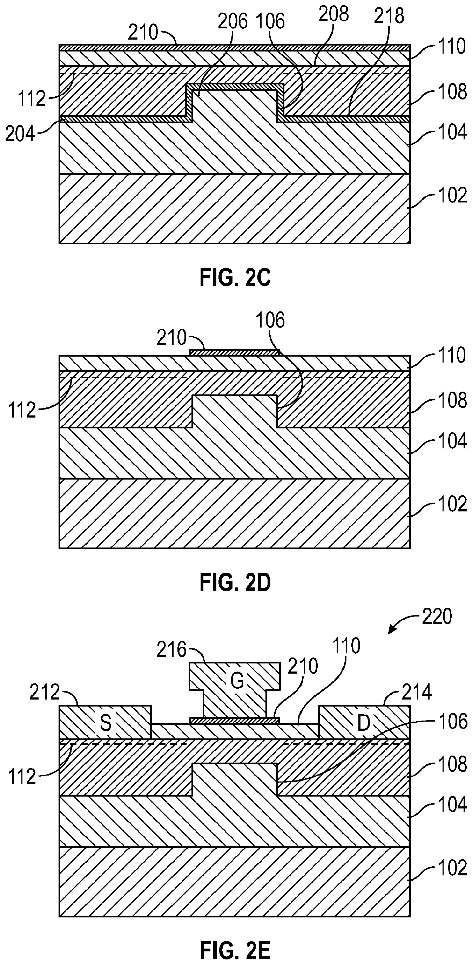

A gate electrode can be formed over the third semiconductor material layer 110 and over the mesa-shaped region 106, such as shown in FIG. 2E. By using the techniques of this disclosure, the mesa-shaped region 106 creates an area under the gate electrode region that has a decreased electron concentration and areas outside of the gate electrode region that have a high electron concentration, which can be desirable for low on-resistance. In this manner, the mesa-shaped region 106 can assist in forming an enhancement mode HEMT device.

FIGS. 2A-2E depict an example of a process flow for fabricating an enhancement mode compound semiconductor heterostructure transistor device, in accordance with this disclosure. In FIG. 2A, a first semiconductor material layer 104, such as AlGaN or AlN, is formed over the substrate 102, such as silicon, silicon carbide (SiC), or sapphire. For example, an AlGaN layer 104 can be grown on silicon substrate 102. The first semiconductor material layer 104, e.g., a back barrier, forms a buried semiconductor layer.

In FIG. 2B, the mesa-shaped region 106 of the first semiconductor material layer 104 is formed. For example, the first semiconductor material layer 104 can be patterned and etched to create the mesa-shaped region 106. In this manner, the regions 200 and 202 are prepared such that there is no depletion of the 2DEG channel 112 (of FIG. 1) from the back barrier, e.g., the first semiconductor material layer 104.

In FIG. 2C, the second semiconductor material layer 108, e.g., a GaN layer, can be formed, e.g., grown, over the first semiconductor material layer 104 at a regrowth interface 204. As described in more detail below, an optional process can be performed before the growth of the second semiconductor to reduce the effects of unintentional dopants at the regrowth interface.

The third semiconductor material layer 110, e.g., AlGaN, is formed over the second semiconductor material layer 108, e.g., GaN, to form a compound semiconductor heterostructure having a 2DEG channel 112. The 2DEG channel 112 is more conductive than either the second semiconductor material layer 108 or the third semiconductor material layer 110.

As seen in FIG. 2C, a top 206 of the mesa-shaped region 106 extends toward a bottom 208 of the third semiconductor material layer 110. In some examples, the top 206 of the mesa-shaped region 106 and the bottom 208 of the third semiconductor material layer 110 are separated by less than 25 nanometers.

In some examples, a fourth semiconductor material layer 210, e.g., p-type material such as p-type GaN or p-type nickel oxide, is formed over the third semiconductor material layer 110. Without being bound by theory, a p-type material, such as p-type GaN, at the surface allows the establishment of a surface potential such that the conduction band is pulled up sufficiently to make an enhancement mode GaN HEMT.

In FIG. 2D, the fourth semiconductor material layer 210 can be patterned and etched to create a portion of material over which a gate electrode (shown in FIG. 2E) can be formed. The fourth semiconductor material layer 210 can have a thickness of between about 5 nanometers (nm) and 60 nm. In some specific examples, the thickness of the fourth semiconductor material layer 210 can be less than about 30 nm.

In FIG. 2E, gate, source, and drain electrodes are formed. A source electrode 212 and a drain electrode 214 are electrically coupled to the 2DEG channel 112. A gate electrode 216 is formed over the third semiconductor material layer 110. In some examples, the gate electrode 216 is formed over the fourth semiconductor material layer 210, e.g., p-type material. In this manner, an enhancement mode HEMT device 220 is formed.

Referring again to FIG. 2C and as mentioned above, an optional process can be performed before the growth of the second semiconductor to reduce the effects of unintentional dopants at the regrowth interface. The process can include reducing or counteracting impurities at the regrowth interface 204.

During semiconductor fabrication, regrowth of GaN by metalorganic chemical vapor deposition (MOCVD) can be performed. GaN MOCVD regrowth, however, can be accompanied by incorporation of impurity dopants, such as silicon (Si), in the regrown film at the regrowth interface. The undesired impurity dopants present in the regrown film can become incorporated into the GaN and reduce the resistance of the GaN and introduce potential leakage paths. In other words, there can be unwanted surface contamination at the regrowth interface that can contribute unwanted charge and form leakage current in the device, e.g., transistor. Various techniques can be used for impurity dopant reduction in GaN regrowth, such as described in detail in commonly assigned PCT application no. PCT/US2021/044355 titled " IMPURITY REDUCTION TECHNIQUES IN GALLIUM NITRIDE REGROWTH," to James G. Fiorenza and Daniel Piedra and filed on August 3, 2021, the entire contents of which being incorporated herein by reference.

In a first technique to reduce or counteract impurities at a regrowth interface, a fifth semiconductor material layer 218, e.g., a barrier layer, can be formed at the regrowth interface 204 before the regrown GaN layer 108. That is, the fifth semiconductor material layer 218 can be formed between the first semiconductor material layer 104 and the second semiconductor material layer 108. Without being bound by theory, the barrier layer can bury the impurities at the regrowth interface and reduce their effect on the layers above that include the channel of the device, e.g., transistor.

In some examples, the barrier layer can have a thickness of about 2 nm. In some examples, the first semiconductor material layer 104 and the fifth semiconductor material layer 218 can include the same semiconductor material. In some examples, the fifth semiconductor material layer 218 includes AlGaN. In other examples, the fifth semiconductor material layer includes AlN.

In a second technique to reduce or counteract impurities at a regrowth interface, a fifth semiconductor material layer 218, e.g., a buffer layer, such as a carbon doped GaN layer, can be formed at the regrowth interface 204 of FIG. 2C before the regrown GaN layer 108. Carbon can act as an acceptor to compensate for the dopants, e.g., silicon, and cancel their electronic effect on the above layers.

In a third technique to reduce or counteract impurities at a regrowth interface, a hydrogen bake treatment can be performed before the GaN regrowth. Hydrogen can desorb a thin layer of GaN at the regrowth interface, which is the GaN layer with the highest concentration of impurities. These techniques are described in detail below.

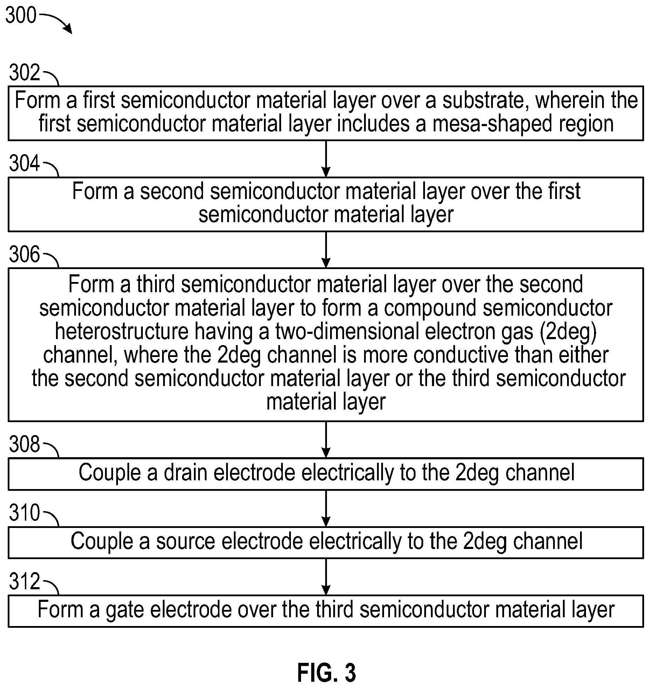

FIG. 3 is a flow diagram of an example of a method 300 of forming a compound semiconductor heterostructure transistor device. At block 302, the method 300 includes forming a first semiconductor material layer over a substrate, where the first semiconductor material layer includes a mesa-shaped region, such as shown in FIGS. 2A and 2B. For example, a layer of AlGaN can be formed over a silicon substrate.

At block 304, the method 300 includes forming a second semiconductor material layer over the first semiconductor material layer, such as shown in FIG. 2C. For example, a layer of GaN can be formed over a layer of AlGaN.

At block 306, the method 300 includes forming a third semiconductor material layer over the second semiconductor material layer to form a compound semiconductor heterostructure having a two-dimensional electron gas (2DEG) channel, where the 2DEG channel is more conductive than either the second semiconductor material layer or the third semiconductor material layer, such as shown in FIG. 2C. For example, a layer of AlGaN can be formed over a layer of GaN.

At block 308, the method 300 includes coupling a drain electrode electrically to the 2DEG channel, such as shown in FIG. 2E. For example, the drain electrode 214 can be electrically coupled to the 2DEG channel 112.

At block 310, the method 300 includes coupling a source electrode electrically to the 2DEG channel, such as shown in FIG. 2E. For example, the source electrode 212 can be electrically coupled to the 2DEG channel 112.

At block 312, the method 300 includes forming a gate electrode over the third semiconductor material layer, such as shown in FIG. 2E. For example, the gate electrode 216 can be formed over the AlGaN layer 110.

In some examples, the method 300 includes forming a fourth semiconductor material layer over the third semiconductor material layer and under the gate electrode. For example, a p-type material, e.g., p-GaN, can be formed over the AlGaN layer and under the gate electrode 216.

In some examples, the method 300 includes reducing or counteracting impurities at a regrowth interface. For example, the method 300 can include forming a fifth semiconductor material layer 218 between the first semiconductor material layer 104 and the second semiconductor material layer 108, such as shown in FIG. 2C, where the fifth semiconductor material layer includes aluminum nitride or aluminum gallium nitride.

In other examples, the fifth semiconductor material layer 218 is a carbon-doped gallium nitride layer 218 between the first semiconductor material layer 104 and the second semiconductor material layer 108, such as shown in FIG. 2C. In some examples, the carbon-doped GaN can have a carbon doping concentration of about 2e19 cm⁻³.

In yet other examples, reducing or counteracting impurities at the regrowth interface includes performing a hydrogen bake treatment before forming the second semiconductor growth region to reduce the impurities at the regrowth interface. The hydrogen bake treatment can include exposing the original growth of assembly, which includes the impurities, such as Si, to a high temperature hydrogen atmosphere to reduce the level of impurities at the regrowth interface 204. The hydrogen bake treatment can be long enough to remove the surface impurities but short enough that the treatment does not etch away too much of any exposed GaN. In an example, the hydrogen bake can occur for about 30 seconds to about 5 minutes at a temperature of about 800 degrees Celsius to about 1100 degrees Celsius at a pressure of about 100 millibars to about 500 millibars.

### ASPECTS OF THE DISCLOSURE

Non-limiting aspects of the disclosure are set out in the following numbered clauses.
1. A compound semiconductor heterostructure transistor device comprising:
   a substrate;
   a first semiconductor material layer formed over the substrate, wherein the first semiconductor material layer includes a mesa-shaped region;
   a second semiconductor material layer formed over the first semiconductor material layer;
   a third semiconductor material layer formed over the second semiconductor material layer to form a compound semiconductor heterostructure having a two-dimensional electron gas (2DEG) channel, wherein the 2DEG channel is more conductive than either the second semiconductor material layer or the third semiconductor material layer;
      a drain electrode electrically coupled to the 2DEG channel;
      a source electrode electrically coupled to the 2DEG channel; and
   a gate electrode formed over the third semiconductor material layer.
2. The compound semiconductor heterostructure transistor device of clause 1, comprising:
   a fourth semiconductor material layer formed over the third semiconductor material layer and under the gate electrode.
3. The compound semiconductor heterostructure transistor device of clause 2, wherein the fourth semiconductor material layer includes a p-type material.
4. The compound semiconductor heterostructure transistor device of clause 2 or clause 3, wherein the fourth semiconductor material layer has a thickness less than 30 nanometers.
5. The compound semiconductor heterostructure transistor device of any preceding clause, wherein a top of the mesa-shaped region extends toward a bottom of the third semiconductor material layer.
6. The compound semiconductor heterostructure transistor device of clause 5, wherein the top of the mesa-shaped region and the bottom of the third semiconductor material layer are separated by less than 25 nanometers.
7. The compound semiconductor heterostructure transistor device of any preceding clause, wherein the compound semiconductor heterostructure transistor device is an enhancement mode transistor device.
8. The compound semiconductor heterostructure transistor device of any preceding clause, comprising:
   a fifth semiconductor material layer formed between the first semiconductor material layer and the second semiconductor material layer.
9. The compound semiconductor heterostructure transistor device of clause 8, wherein the first and fifth semiconductor material layers include the same semiconductor material.
10. The compound semiconductor heterostructure transistor device of clause 8 or clause 9, wherein the fifth semiconductor material layer includes aluminum gallium nitride.
11. The compound semiconductor heterostructure transistor device of any of clauses 8 to 10, wherein the fifth semiconductor material layer includes aluminum nitride.
12. A method of forming a compound semiconductor heterostructure transistor device, the method comprising:
   forming a first semiconductor material layer over a substrate, wherein the first semiconductor material layer includes a mesa-shaped region;
   forming a second semiconductor material layer over the first semiconductor material layer;
   forming a third semiconductor material layer over the second semiconductor material layer to form a compound semiconductor heterostructure having a two-dimensional electron gas (2DEG) channel, wherein the 2DEG channel is more conductive than either the second semiconductor material layer or the third semiconductor material layer;
   coupling a drain electrode electrically to the 2DEG channel;
   coupling a source electrode electrically to the 2DEG channel; and
   forming a gate electrode over the third semiconductor material layer.
13. The method of clause 12, comprising:
   forming a fourth semiconductor material layer over the third semiconductor material layer and under the gate electrode.
14. The method of clause 13, wherein forming the fourth semiconductor material layer over the third semiconductor material layer and under the gate electrode comprises:
   forming a p-type material over the third semiconductor material layer and under the gate electrode.
15. The method of any of clauses 12 to 14, comprising:
   reducing or counteracting impurities at a regrowth interface.
16. The method of clause 15, wherein reducing or counteracting impurities at the regrowth interface comprises:
   forming a fifth semiconductor material layer between the first semiconductor material layer and the second semiconductor material layer, wherein the fifth semiconductor material layer includes aluminum nitride or aluminum gallium nitride.
17. The method of clause 15 or clause 16, wherein reducing or counteracting impurities at the regrowth interface comprises:
   forming a carbon-doped gallium nitride layer between the first semiconductor material layer and the second semiconductor material layer.
18. The method of any of clauses 15 to 17, wherein reducing or counteracting impurities at the regrowth interface comprises:
   performing a hydrogen bake treatment before forming the second semiconductor material layer to reduce the impurities at the regrowth interface.
19. A compound semiconductor heterostructure transistor device comprising:
   a substrate;
   a first semiconductor material layer formed over the substrate, wherein the first semiconductor material layer includes a mesa-shaped region;
   a second semiconductor material layer formed over the first semiconductor material layer;
   a third semiconductor material layer formed over the second semiconductor material layer to form a compound semiconductor heterostructure having a two-dimensional electron gas (2DEG) channel, wherein the 2DEG channel is more conductive than either the second semiconductor material layer or the third semiconductor material layer;
   a drain electrode electrically coupled to the 2DEG channel;
   a source electrode electrically coupled to the 2DEG channel;
   a gate electrode formed over the second semiconductor material layer; and
   a fourth semiconductor material layer formed over the third semiconductor material layer and under the gate electrode.
20. The compound semiconductor heterostructure transistor device of clause 19, wherein the fourth semiconductor material layer includes a p-type material.

### Various Notes

Each of the non-limiting aspects or examples described herein may stand on its own or may be combined in various permutations or combinations with one or more of the other examples.

The above detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following aspects, the terms "including" and "comprising" are open-ended, that is, a system, device, article, composition, formulation, or process that includes elements in addition to those listed after such a term in an aspect are still deemed to fall within the scope of that aspect. Moreover, in the following aspects, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or nonvolatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the aspects. Also, in the above Detailed Description, various features may be grouped together to streamline the disclosure. This should not be interpreted as intending that an unclaimed disclosed feature is essential to any aspect. Rather, inventive subject matter may lie in less than all features of a particular disclosed embodiment. Thus, the following aspects are hereby incorporated into the Detailed Description as examples or embodiments, with each aspect standing on its own as a separate embodiment, and it is contemplated that such embodiments may be combined with each other in various combinations or permutations. The scope of the invention should be determined with reference to the appended aspects, along with the full scope of equivalents to which such aspects are entitled.

## Claims

1. A compound semiconductor heterostructure transistor device comprising:
a substrate;
a first semiconductor material layer formed over the substrate, wherein the first semiconductor material layer includes a mesa-shaped region;
a second semiconductor material layer formed over the first semiconductor material layer;
a third semiconductor material layer formed over the second semiconductor material layer to form a compound semiconductor heterostructure having a two-dimensional electron gas (2DEG) channel, wherein the 2DEG channel is more conductive than either the second semiconductor material layer or the third semiconductor material layer;
a drain electrode electrically coupled to the 2DEG channel;
a source electrode electrically coupled to the 2DEG channel; and
a gate electrode formed over the third semiconductor material layer.

2. The compound semiconductor heterostructure transistor device of claim 1, comprising:
a fourth semiconductor material layer formed over the third semiconductor material layer and under the gate electrode.

3. The compound semiconductor heterostructure transistor device of claim 2, wherein the fourth semiconductor material layer includes a p-type material.

4. The compound semiconductor heterostructure transistor device of claim 2 or claim 3, wherein the fourth semiconductor material layer has a thickness less than 30 nanometers.

5. The compound semiconductor heterostructure transistor device of any preceding claim, wherein a top of the mesa-shaped region extends toward a bottom of the third semiconductor material layer;
and optionally wherein the top of the mesa-shaped region and the bottom of the third semiconductor material layer are separated by less than 25 nanometers.

6. The compound semiconductor heterostructure transistor device of any preceding claim, wherein the compound semiconductor heterostructure transistor device is an enhancement mode transistor device.

7. The compound semiconductor heterostructure transistor device of any preceding claim, comprising:
a fifth semiconductor material layer formed between the first semiconductor material layer and the second semiconductor material layer.

8. The compound semiconductor heterostructure transistor device of claim 7, wherein the first and fifth semiconductor material layers include the same semiconductor material.

9. The compound semiconductor heterostructure transistor device of claim 7 or claim 8, wherein the fifth semiconductor material layer includes aluminum gallium nitride.

10. The compound semiconductor heterostructure transistor device of any of claims 7 to 9, wherein the fifth semiconductor material layer includes aluminum nitride.

11. A method of forming a compound semiconductor heterostructure transistor device, the method comprising:
forming a first semiconductor material layer over a substrate, wherein the first semiconductor material layer includes a mesa-shaped region;
forming a second semiconductor material layer over the first semiconductor material layer;
forming a third semiconductor material layer over the second semiconductor material layer to form a compound semiconductor heterostructure having a two-dimensional electron gas (2DEG) channel, wherein the 2DEG channel is more conductive than either the second semiconductor material layer or the third semiconductor material layer;
coupling a drain electrode electrically to the 2DEG channel;
coupling a source electrode electrically to the 2DEG channel; and
forming a gate electrode over the third semiconductor material layer.

12. The method of claim 11, comprising:
forming a fourth semiconductor material layer over the third semiconductor material layer and under the gate electrode.

13. The method of claim 12, wherein forming the fourth semiconductor material layer over the third semiconductor material layer and under the gate electrode comprises:
forming a p-type material over the third semiconductor material layer and under the gate electrode.

14. The method of any of claims 11 to 13, comprising:
reducing or counteracting impurities at a regrowth interface.

15. The method of claim 14, wherein reducing or counteracting impurities at the regrowth interface comprises any one or more of:
(a) forming a fifth semiconductor material layer between the first semiconductor material layer and the second semiconductor material layer, wherein the fifth semiconductor material layer includes aluminum nitride or aluminum gallium nitride;
(b) forming a carbon-doped gallium nitride layer between the first semiconductor material layer and the second semiconductor material layer;
(c) performing a hydrogen bake treatment before forming the second semiconductor material layer to reduce the impurities at the regrowth interface.
